# EUROPEAN PATENT SPECIFICATION

(11) **EP 1 431 018 B1**
(45) Date of publication and mention of the grant of the patent: **11.11.2015**
(21) Application number: 02777795.2
(22) Date of filing: 26.09.2002
(51) Int. Cl.: G03F 7/00, G03F 7/095, G03F 7/20, B29C 33/38, B29C 33/42

(54) **METHOD OF PRODUCING RESIN MOLDED PRODUCT**
VERFAHREN ZUR HERSTELLUNG EINES GEFORMTEN HARZPRODUKTS
PROCEDE DE PRODUCTION D'UN PRODUIT MOULE EN RESINE

(30) Priority: 28.09.2001 JP 2001299059
(43) Date of publication of application: 23.06.2004
(73) Proprietor: KURARAY CO., LTD., Kurashiki-shi, Okayama 710-8622 (JP)
(72) Inventor: NISHI, Taiji, c/o KURARAY Co., Ltd., Tsukuba-shi, Ibaraki 305-0841 (JP); YANAGAWA, Yukihiro, c/o KURARAY Co., Ltd., Kashima-gun, Ibaraki 314-0197 (JP); Kawahara, Shigeru c/o Kuraray Co, Ltd, Tsukuba-shi Ibaraki 305-0841 (JP)
(74) Representative: Vossius & Partner Patentanwälte Rechtsanwälte mbB
(86) International application number: PCT/JP2002/009931
(87) International publication number: WO 2003/028970

(56) References cited:
- EP-A2- 0 163 089
- WO-A-91/16966
- GB-A- 2 245 084
- JP-A- 4 256 393
- JP-A- 2001 338 444
- US-A- 5 722 162
- US-A1- 5 209 688
- US-A1- 5 716 741
- US-A1- 5 930 890
- GINA M. CALDERON, KEVIN J. MORRIS, OLGA VLADIMIRSKY, YULI VLADIMIRSKY: "Multilevel 3D patterning of stacked PMMA sheets for x-ray microlithography" PROCEEDINGS OF SPIE, vol. 2880, September 1996 (1996-09), pages 231-235, XP002425201
- DELLMANN, L. ROTH, S. BEURET, C. RACINE, G.-A. LORENZ, H. DESPONT, M. RENAUD, P. VETTIGER, P. DE ROOIJ, N.F.: "Fabrication Process Of High Aspect Ratio Elastic Structures For Piezoelectric Motor Applications" SOLID TATE SENSORS AND ACTUATORS, vol. 1, 16 June 1997 (1997-06-16), - 19 June 1997 (1997-06-19) pages 641-644, XP002425202 Chicago, IL, USA
- B. LÖCHEL, A. MACIOSSEK, M. KÖNIG, H. J. QUENZER, H.-L. HUBER: "Galvanoplated 3D Structures for Micro Systems" MICROELECTRONIC ENGINEERING, vol. 23, 1994, pages 455-459, XP002425203
- JUN-BO YOON, JAE-DUK LEE, CHUL-HI HAN, EUISIK YOON, CHOONG-KI KIM: "Multilevel microstructure fabrication using single-step 3D photolithography and single-step electroplating" PROCEEDINGS OF SPIE, vol. 3512, September 1998 (1998-09), pages 358-366, XP002425204

## Description

### Technical Field

The present invention relates to a process for producing an accurate and low-cost resin molded product having a desired pattern depth, and a resin molded product produced by this process. The process according to this invention is particularly effective in producing a resin molded product used for diagnosis, reaction, separation, and measurement in the medical, industrial, and biotechnological fields, for example. Since the resin molded product according to this invention, and particularly the product used in the medical field, has a microstructure, it allows shortening of measuring time, reduction of sample amount, and parallel processing, thus being effectively applicable, for example, to diagnosis at a medical center clinical laboratory, bedside, operating room, local clinic, home, and so on.

### Background Art

As societies mature, values on medical care and health have changed. People now seek a healthy and high-quality life, not merely a primary health care. It is expected that more and more individuals will place a higher value on preventive medicine than on curative medicine due to rising medical care costs, disease prevention being less costly than treatment, and an increasing number of those who are in between healthy and diseased. On this account, in the medical field and particularly in the clinical laboratory field, there is an increasing need for a non-restraint examination system that enables prompt examination and diagnosis in the vicinity of a patient such as at an operating room, bedside, and home, and a noninvasive or minimally invasive examination system that requires only a small amount of sample of blood and so on.

In order to achieve the non-restraint examination system allowing prompt examination and diagnosis, it is necessary, for example, to provide portability to the system by downsizing a substrate used in examination and diagnosis.

Recently, micromachine technology has attracted attention as a new approach to provide portability to chemical analyzers. For example, there are two main types of automated systems of colorimetric analysis that is a mainstream method for biochemical analysis and so on: the one that generates dynamic convection to mix two solutions thereby and the other that disperses two solutions in each other to mix them by molecular diffusion. The molecular diffusion mixing is becoming a mainstream method since it is capable of rapid mixing and suitable for reduction of sample requirements and downsizing of the system. With the micromachine technology, if the diameter of a flow channel is reduced from 1 mm to 0.1 mm, for example, it not only reduces sample requirements but also shortens mixing time to one-tenth. This will allow the system to perform the same function as conventional large-size systems while being portable. Further, the miniaturization of the flow channel will allow arrangement of a plurality of flow channels in one substrate, enabling parallel processing.

With the worldwide progress of the human genome project, a number and types of diseases for which DNA diagnosis is possible is ever-increasing. Consequently, various diseases which have been indirectly diagnosed by the biochemical analysis can now be definitively diagnosed at a DNA level to determine the cause and mechanism of the diseases.

Widely used methods for the DNA diagnosis are capillary electrophoresis and PCR (Polymerase Chain Reaction). The PCR method provides an extremely sensitive means of amplifying small quantities of genome samples 100,000 times or more for detection. The capillary electrophoresis method, on the other hand, injects a sample into a capillary with a diameter of 100 to 200 µm to separate molecules in the sample. If the capillary diameter can be reduced, more rapid diagnosis will be achieved. The reduction of the capillary diameter will also allow arrangement of a plurality of capillaries in one substrate, enabling parallel processing.

In the clinical laboratory field, there is a need for miniaturization of reservoirs to reduce the quantity of expensive antibody and substrate used for immunoassay and so on.

If a plurality of flow channels, mixing parts, and reservoirs can be placed in one substrate by their miniaturization, it will be possible to perform the capillary electrophoresis and the PCR on the same substrate.

Further, the miniaturization of reservoirs used in examination and diagnosis are also needed to achieve the noninvasive or minimally invasive examination system that requires only a small amount of sample such as blood.

Besides the clinical laboratory field, the biochemistry field also has a need for the miniaturization to enable more rapid operation, smaller sample requirements, reduced waste solution, and so on.

Conventionally, resin molded products have been produced by injection molding, blow molding, or press molding by using a metal mold formed by molding or machining.

However, producing the metal mold by molding has a limitation in mold accuracy, and producing the metal mold by machining has a limitation in downsizing of a cutting tool and cutting accuracy. For these reasons, neither processing technique achieves a molded product with an accurate and fine pattern.

Thus, if the conventional resin molded product is used in a chemical analyzer for biochemical analysis and so on, for example, it is unable to reduce mixing time (diagnosis time) and provide portability to the system due to a limitation in flow path accuracy and miniaturization.

Similarly, if the conventional resin molded product is used in DNA diagnosis including diagnosis by the capillary electrophoresis, it is unable to reduce sample injection and separation time (diagnosis time) and downsize a substrate due to a limitation in flow path accuracy and miniaturization.

If the conventional resin molded product is used in the medical field, particularly for a sample reservoir in the clinical laboratory field, it is necessary to use a large amount of sample such as blood and is unable to provide portability to an examination and diagnosis system due to a limitation in chamber accuracy and miniaturization.

Further, if the conventional resin molded product is used in the medical field, for example for immunoassay, it is unable to reduce the amount of expensive antibody and substrate to be used due to a limitation in chamber accuracy and miniaturization.

Another known processing technique to solve the above problems is microfabrication, which applies semiconductor microfabrication technology, to create a micropattern on a glass or silicon substrate by wet etching or dry etching.

The wet etching, however, is not an accurate technique since width (or diameter) accuracy degrades if a pattern depth becomes 0.5 mm or more due to under etching at the bottom of a masking material.

The dry etching is a technique developed from a patterning process of a silicon (Si) semiconductor, and its application to various electronic components and compound semiconductors using various plasma sources has been studied.

Though the dry etching can create superior micropattern, its etching speed is as slow as 500 to 2,000 nm/min., and it takes 50 minutes or more to create a pattern depth of 0.1 mm, for example. The dry etching is thus not a productive or low-cost technique.

Besides, if the dry etching process time reaches one hour, system electrodes become heated, causing deformation of a substrate and damage to a device. Thus, when the system electrodes become as hot as more than 60°C, it is necessary to suspend the system operation and then restart the processing, which further decreases the productivity.

Another known processing technique to solve the above problems is a lithography technique.

The lithography technique applies a resist coating to a substrate, exposes the resist layer, and creates a resist pattern by development. Then, this technique deposits a metal structure in accordance with the resist pattern on the substrate by electroplating, and produces a resin molded product using the metal structure as a mold. The lithography technique can produce 50,000 or more products from one metal structure, and applications of this technique include laserdiscs, CD-ROMs, and minidisks. This technique enables accurate and low-cost production, thus being highly productive. Further, since a material to be processed by this technique is not silicon, applications of this technique are expected to expand.

However, the lithography technique, whose typical applications include laserdiscs, CD-ROMs, and minidisks, is mainly used for producing a molded product with the pattern depth of about 1 to 3 µm. Hence, this technique is currently not used for producing a flow channel or a reservoir having the pattern depth of 100 µm, for example.

In order to achieve 100 µm or more pattern depth by the lithography technique, synchrotron radiation may be used as exposure light. The synchrotron radiation is highly directional like laser light, and the short wavelength light, which cannot be produced by a laser, overcomes a diffraction limit that hampers the microfabrication. Thus, use of the synchrotron radiation as exposure light can create a fine and deep pattern.

However, the synchrotron radiation facilities cost 3 to 5 billion yen for the system only. The cost of a metal structure produced by the lithography technique using the synchrotron radiation facilities is estimated at approximately 3 to 5 million yen per piece. Accordingly, a resin molded product produced thereby costs about twenty times or more higher than that produced by the lithography technique using UV light, though it depends on the number of products to be molded. It is thereby unable to expand it as a low-cost product.

United States Patent No. 5,722,162 (and the corresponding Japanese Unexamined Patent Application Publication No. 09-199663) discloses a technique that forms two photoresist layers on a substrate and creates an opening. This is, however, introduced as a technique to create a post on a substrate, not to produce a molded product. Further, the exposure on the first photoresist layer and that on the second photoresist are performed in a different way.

US 5,716,741 discloses high-precision stepped microstructure bodies, stepped mould inserts and a method of producing the same.

In Proceedings of SPIE, vol. 2880 (1996), 231 - 235 G. Calderon et al. deal with a technique for producing 3D patterns in a thick layered resist.

In Solid-State Sensors and Actuators, vol. 1 (1997), 641 - 644 L. Dellmann et al. describe a process for producing high aspect ratio elastic structures.

A. Schmidt et al deal with aligned double exposure in deep X-ray lithography in Microelectronic Engineering 30 (1996), 235 - 238.

EP 06 07 680 A2 describes a method for forming microstructures using a performed photoresist sheet.

EP 0 024 515 A1 deals with a process for producing separating nozzles.

A single level masking process with two positive photoresist layers is described in US 4,088,490.

Iin view of the foregoing, it is an object of the present invention to provide a process for producing an accurate and low-cost molded product having a desired pattern depth. Particularly, the present invention aims at providing a highly productive process for producing a molded product used for diagnosis, reaction, separation, and measurement in the medical, industrial, biotechnological and other fields, and a process for producing a mold used therefor.

It is another object of the present invention to provide a molded product having a microstructure to enable measurement time reduction, minimal sample requirements, and parallel processing, available for use at a medical center clinical laboratory, bedside, operating room, local clinic, home, and so on.

### Disclosure of the Invention

As a result of extensive studies to solve the above problems, the inventors of the present invention have discovered that an accurate and low-cost molded product with a desired pattern depth can be produced by repeating resist coating, exposure, and mask positioning a plurality of times, and that this process is particularly effective in producing a molded product used in the medical, industrial, biotechnological and other fields, thereby accomplishing the present invention.

Specifically, a process for producing a molded product according to the present invention includes a resist pattern formation step for forming a resist layer on a substrate and performing exposure using a mask and development; a metal structure formation step for depositing by plating a metal structure in accordance with the resist pattern formed on the substrate; and a molded product formation step for forming a resin molded product by using the metal structure as a mold; wherein the resist pattern formation step includes a step for forming a first resist layer on the substrate and performing exposure on the first resist layer; and a step for forming a second resist layer on the first resist layer and performing exposure, or exposure and development on the second resist layer and wherein the depth of a concave part of the resin molded product formed by the molded product formation step is 20 to 500 µm. This process allows producing an accurate and low-cost molded product having a desired pattern depth.

In a preferred embodiment, the resist pattern formation step in the above process for producing a molded product is repeated a plurality of times until a desired thickness of the resist layer is reached.

In the above process for producing a molded product the mask position may be adjusted for the exposure of the second resist layer to be in the same position as for the exposure of the first resist layer. By performing this step, the pattern accuracy of the molded product increases.

Further, the first resist layer and the second resist layer may be formed of different resists having different sensitivities. This prevents the width of the top surface of the resist from becoming larger than that of the bottom of the resist.

If a light source used for the exposure in the resist pattern formation step is a ultraviolet lamp or a laser, the production process according to the present invention is particularly suitable. This is because, unlike the synchrotron radiation, the ultraviolet lamp or the laser cannot make deep exposure, thus incapable of exposure of a thick resist layer.

Further, the depth of a concave part of the resin molded product formed by the molded product formation step is 20 to 500 µm, and preferably 50 to 300 µm.

Further, according to the present invention, the other of the foregoing objects is achieved by providing a resin molded product satisfying the above conditions.

A process for producing a metal mold according to the present invention includes a resist pattern formation step for forming a resist layer on a substrate and performing exposure using a mask and development; and a metal structure formation step for depositing by plating a metal structure in accordance with the resist pattern formed on the substrate to form a metal mold, wherein the resist pattern formation step includes a step for forming a first resist layer on the substrate and performing exposure on the first resist layer; and a step for forming a second resist layer on the first resist layer and performing exposure, or exposure and development on the second resist layer, wherein the metal mold is such that the depth of a concave part of a resin molded product formed by using the metal mold is 20 to 500 µm. This process allows producing an accurate and low-cost metal mold having a desired pattern depth.

In a preferred embodiment, the resist pattern formation step in the above process for producing a metal mold is repeated a plurality of times until a desired thickness of the resist layer is reached.

In the above process for producing a metal mold the mask position may be adjusted for the exposure of the second resist layer to be in the same position as for the exposure of the first resist layer. By performing this step, the pattern accuracy of the metal mold increases.

Further, the first resist layer and the second resist layer may be formed of different resists having different sensitivities. This prevents the width of the top surface of the resist from becoming larger than that of the bottom of the resist.

### Brief Description of the Drawings

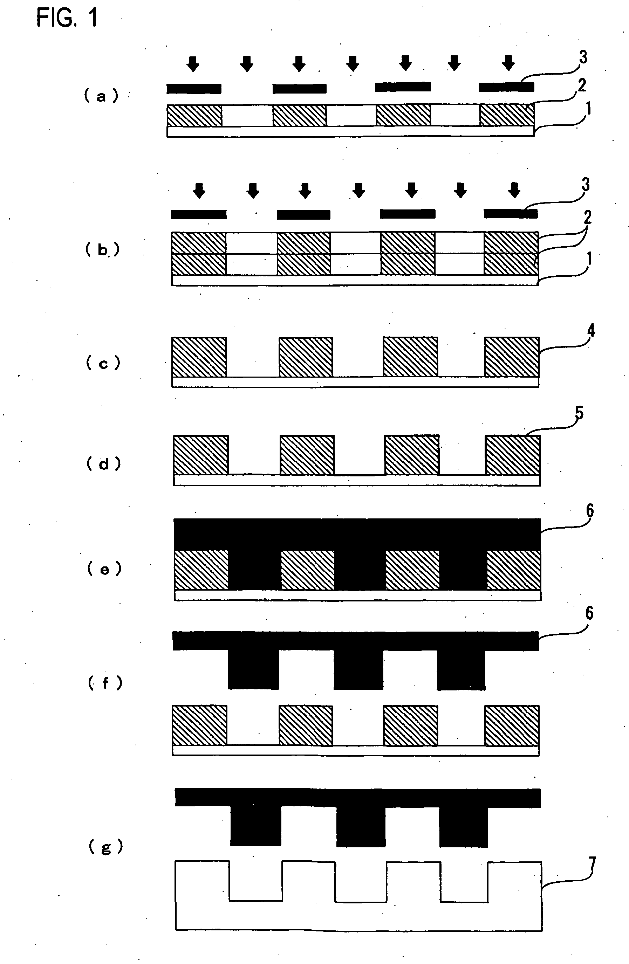

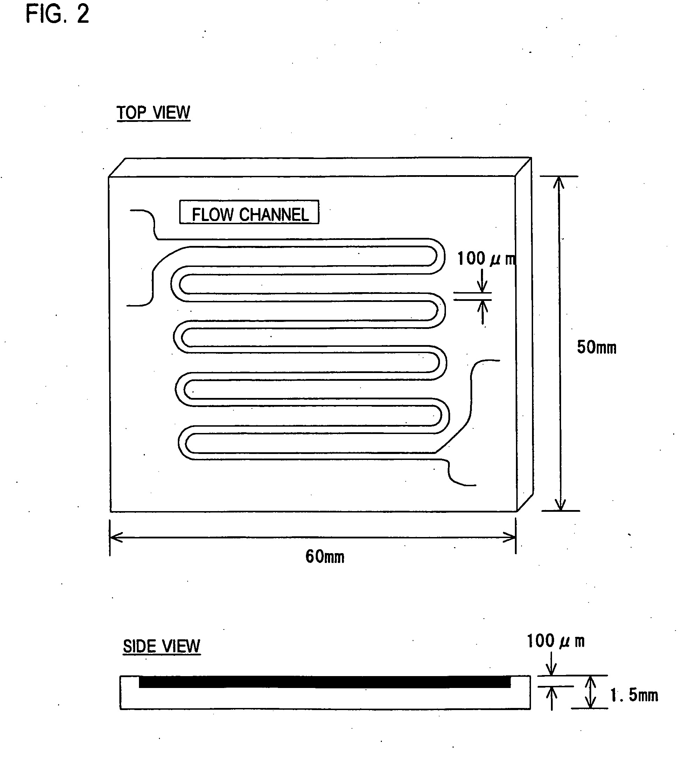

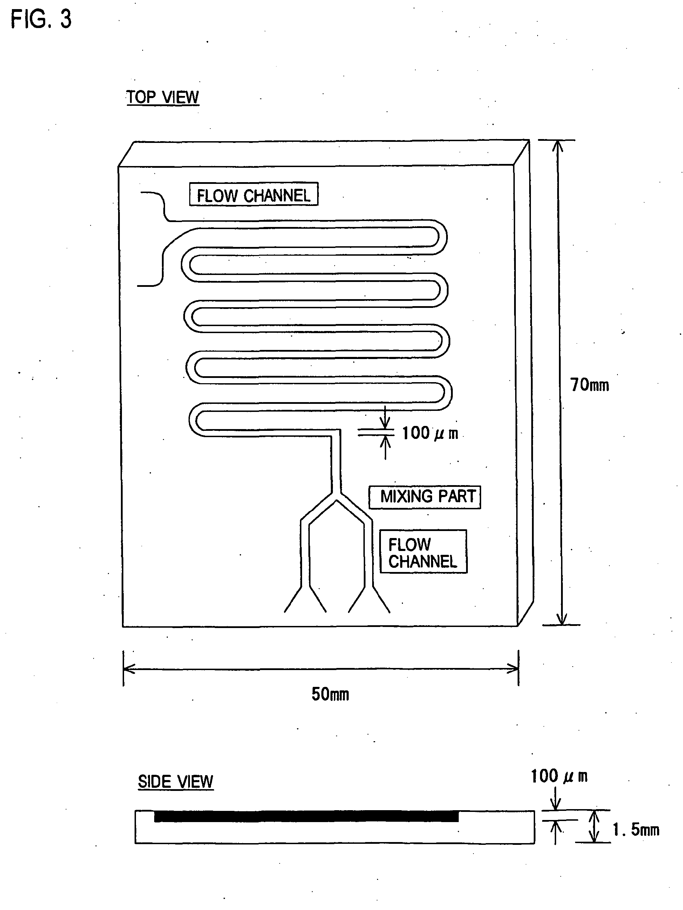

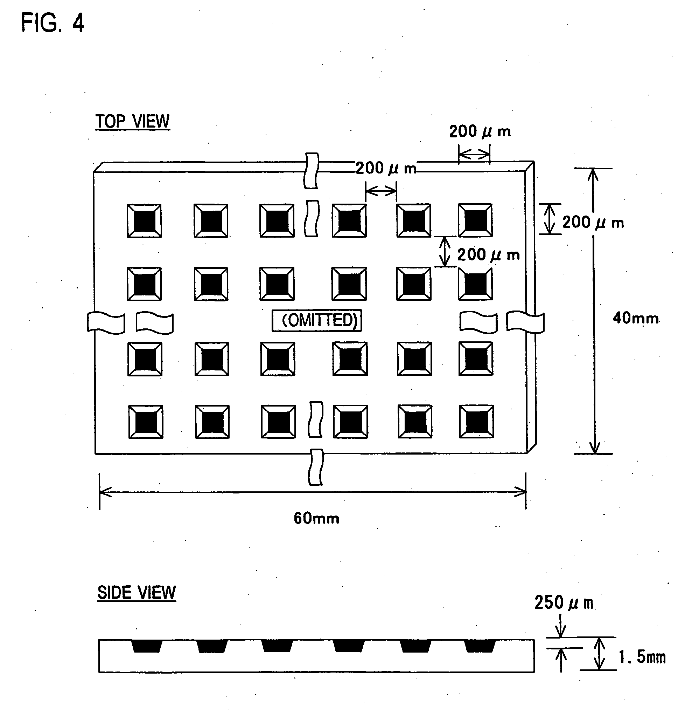

Fig. 1 is a view showing a process for producing a molded product. Fig. 2 is a view showing a molded product having a flow channel produced by the process for producing a molded product shown in Fig. 1. Fig. 3 is a view showing a molded product having a flow channel and a mixing part produced by the process for producing a molded product shown in Fig. 1. Fig. 4 is a view showing a molded product having a reservoir produced by the process for producing a substrate shown in Fig. 1.

### Best Modes for Carrying Out the Invention

The present invention will be explained hereinafter in detail.

A resin molded product according to this invention is produced as follows. Firstly, a resist pattern formation step is performed to form a resist pattern. In this step,
(a) formation of the first resist layer on a substrate
(b) exposure of the first resist layer using a mask
(c) formation of the second resist layer
(d) mask positioning
(e) exposure of the second resist layer are performed, and the steps (c) to (e) are repeated a plurality of times until a desired thickness of the resist layer is reached. Then, development is performed to form a desired resist pattern. Secondly, a metal structure formation step is performed to deposit a metal structure in accordance with the resist pattern by plating. Finally, a molded product formation step is performed to form a resin molded product by using the metal structure as a mold.

The resist pattern formation step will be detailed hereinbelow.
(a) The formation of the first resist layer on a substrate will be explained. The flatness of the resin molded product obtained in the molded product formation step is determined by the operation of applying a resist coating on a substrate. Thus, the flatness of the resist layer when it is deposited on the substrate is reflected in the flatness of the metal structure and the resin molded product eventually.

The first resist layer may be formed on the substrate by any technique, including spin coating, dip coating, roll coating, and dry film resist lamination. The spin coating technique, which deposits resist on a spinning glass substrate, allows very flat coating of the resist on the glass substrate with the size of more than 300 mm in diameter. The spin coating is thus preferred for use to achieve high flatness.

There are two types of resist that may be used: positive and negative. Since the depth of focus on the resist changes depending on exposure conditions, when using a UV exposure system, for example, it is preferred to adjust exposure time and UV output level according to the type, thickness, and sensitivity of the resist.

In the case of using wet resist, viscosity adjustment is required. To obtain a given resist thickness by the spin coating, for example, increasing a resist viscosity is effective, but it can degrade the flatness when a deposition area is large. It is thus preferred to adjust the resist viscosity according to the flatness level required for practical use.

The thickness of the first resist layer is preferably 10 to 50 µm, and more preferably 20 to 50 µm to maintain the high flatness.
(b) The exposure of the first resist layer using a mask will be explained. Any type of mask may be used, including an emulsion mask and a chrome mask. In the resist pattern formation step, sizes such as a flow channel width, depth, a reservoir interval, width (or diameter), and depth, and accuracy are determined by the mask used. The sizes and accuracy are reflected in the resin molded product. Thus, to obtain the resin molded product having given sizes and accuracy, it is necessary to specify the size and accuracy of the mask. There are various techniques to increase the accuracy of the mask. One technique is to use shorter wavelength laser light in the mask pattern formation, but it requires high facility costs, resulting in higher mask fabrication costs. It is preferred to specify the mask accuracy according to the accuracy level required for practical use of the resin molded product.

The light used for the exposure is preferably UV light or laser light for low facility costs. Though the synchrotron radiation can make deep exposure, it requires high facility costs and thus substantially increases the cost of the resin molded product, being industrially impractical.

Since exposure conditions such as exposure time and intensity change depending on the material, thickness, and so on of the first resist layer, they are preferably adjusted according to the pattern to be created. The adjustment of the exposure conditions is critical because it affects the accuracy and the sizes of a pattern such as the width and depth of a flow channel and the interval, width (or diameter), and depth of a reservoir. Further, since the depth of focus changes depending on the resist type, when using the UV exposure system, for example, it is preferred to adjust exposure time and UV output level according to the thickness and sensitivity of the resist.
(c) The formation of the second resist layer will be explained. The second resist layer may be formed by any process, including spin coating, dip coating, roll coating, and dry film resist lamination. When forming the second resist layer by the spin coating, for example, it is able to obtain high flatness but is often unable to obtain necessary resist thickness and flatness in one resist layer formation operation. The thickness and flatness of the resist layer on the substrate is reflected in the pattern depth and flatness of the metal structure and the resin molded product eventually. Thus, it is preferred to form the first resist layer with such a thickness that high flatness is maintained, and then form the second resist layer with such a thickness that high flatness is maintained so as to obtain the necessary resist thickness. The flatness of the entire resist layer can be thereby kept high; accordingly, the flatness of the resin molded product is also high.

The resist used for the second resist layer may be the same as or different from the resist used for the first resist layer. It is preferred to select the resist according to a desired shape, pattern depth, and accuracy.
(d) The mask positioning will be explained. The mask positioning is performed in order to place a mask pattern to be printed on the second resist layer in the same position as the mask pattern printed on the first resist layer.

As the resist becomes thick, it is sometimes unable to obtain sufficient depth of focus with one-time exposure when using the UV exposure system, for example. To solve this problem, the process according to this invention exposes the resist thickness that can be exposed with one-time exposure, and, if a desired resist thickness is not reached, repeats the resist coating, mask positioning, and exposure a plurality of times until a given resist thickness is reached, thereby obtaining a sufficient depth of focus.

If the mask positioning operation fails to place the mask pattern to be printed on the second resist layer in the same position as the mask pattern printed on the first resist layer, it seriously affects the pattern accuracy of the molded product. Hence, positioning error is preferably within the range of ±2 µm, and more preferably within the range of ±1 µm.

There are various techniques to increase the accuracy of the mask positioning, including an offset adjustment method that uses the difference of light diffraction between an exposed part and a non-exposed part. Another method to increase the mask positioning accuracy is to draw a mark on a specific location of the substrate and the mask by laser light and thereby adjust their positions using an optical microscope and so on.
(e) The exposure of the second resist layer will be explained. The light source and conditions in this exposure may be the same as or different from those in the exposure of the first resist layer. Since the exposure conditions such as exposure time and intensity also significantly change depending on the material, thickness, and so on of the second resist layer, they are preferably adjusted according to the pattern to be created.

The step (c) to (e) may be repeated until a desired resist thickness is reached.

After obtaining the desired thickness of the resist by the step (a) to (e), the development step is performed, thereby substantially forming a resist pattern. Though the development process may be performed twice or more after the second resist layer formation, preferably it is performed only once after the formation of the final layer for higher productivity and pattering accuracy.

It is preferred in the development process to use designated developer for the resist used. The development conditions such as development time, development temperature, and developer concentration are preferably adjusted according to the resist thickness and pattern shape. For example, too long development time causes the reservoir interval and width (or diameter) to be larger than a given size.

As the resist layer becomes thick, the width (or diameter) of the top surface of the resist may become undesirably larger than that of the bottom of the resist in the development step. Thus, it is preferred in some cases to form different resist with different sensitivity in each resist layer formation step. In this case, for example, the different resist layers may be laminated so that the sensitivity of the resist layer closer to the top is higher than that of the resist layer closer to the bottom. Specifically, BMR C-1000PM manufactured by TOKYO OHKA KOGYO CO., LTD. may be used as the higher sensitivity resist and PMER-N-CA3000PM manufactured by TOKYO OHKA KOGYO CO., LTD. may be used as the lower sensitivity resist. Alternatively, the sensitivity may be adjusted by changing the length of drying time of the resist. For example, in the case of using BMR C-1000PM manufactured by TOKYO OHKA KOGYO CO., LTD., by drying the first resist layer for 40 minutes at 110°C and the second resist layer for 20 minutes at 110°C in a resist drying operation after the spin coating, it allows the first layer to have the higher sensitivity.

Methods to obtain the molded product with uniform accuracy and depth of the flow channel, mixing part, reservoir, and so on include changing the type of resist (negative or positive) used for the resist coating, and polishing the surface of the metal structure.

Now, the metal structure formation step will be detailed hereinbelow. The metal structure formation step deposits a metal in accordance with the resist pattern formed by the resist pattern formation step to obtain the metal structure.

In this step, a conductive layer is formed initially in accordance with the resist pattern. Though any technique may be used for the formation of the conductive layer, it is preferred to use vapor deposition, sputtering, and so on. A conductive material used for the conductive layer may be gold, silver, platinum, copper, or the like.

After forming the conductive layer, the metal is deposited in accordance with the pattern by plating, thereby forming the metal structure. Any plating method may be used for the deposition of the metal, including electroplating and electroless plating. Though any metal may be used, including nickel, copper, and gold, nickel is preferred since it is less costly and durable.

The metal structure may be polished depending on its surface condition. In this case, to prevent contaminations from attaching to the product, it is preferred to perform ultrasonic cleaning after the polishing.

Further, it is also possible to perform surface treatment of the metal structure by using mold release agent and so on in order to improve the surface condition.

The molded product formation step will now be detailed hereinbelow. The molded product formation step uses the metal structure as a mold to form the resin molded product.

Any technique may be used for the formation of the resin molded product, including injection molding, press molding, monomer casting, solution casting, and roll transfer by extrusion molding. The injection molding is preferred for its high productivity and pattern reproducibility. In producing the resin molded product by the injection molding using the metal structure having a given size as a mold, it allows reproducing the shape of the metal structure with a high reproduction rate.

The reproduction rate may be checked by using an optical microscope, a scanning electron microscope (SEM), a transmission electron microscope (TEM), and so on.

In the case of producing the resin molded product using the metal structure as a mold by the injection molding, for example, 10,000 to 50,000 pieces or even 200,000 pieces of resin molded products may be produced with one metal structure. It is thus possible to largely eliminate the costs for producing the metal structures.

Besides, one cycle of the injection molding takes only 5 to 30 seconds, being highly productive. The productivity further increases with the use of a mold capable of simultaneous production of a plurality of resin molded products in one injection molding cycle.

In this molded product formation step, the metal structure may be used as a metal mold; alternatively, it may be placed inside a prepared metal mold.

Any resin material may be used for the formation of the resin molded product, including acrylic resin, polylactide resin, polyglycolic acid resin, styrene resin, acrylic-styrene copolymer (MS resin), polycarbonate resin, polyester resin such as polyethylene terephthalate, polyvinyl alcohol resin, ethylene-vinyl alcohol copolymer, thermoplastic elastomer such as styrene elastomer, vinyl chloride resin, and silicone resin such as polydimethylsiloxane.

The above resin may contain one or more than one agent of light stabilizer, heat stabilizer, antifogging agent, pigment, flame retardant, antistatic agent, mold release agent, antiblocking agent, ultraviolet absorbent, antioxidant, and so on.

In the following, the resin molded product produced by the above process will be explained in detail.

The sizes and accuracy of the resin molded product are preferably adjusted in each step of the above process according to the level required for practical use.

The sizes of the flow channel, the mixing part, the reservoir, and so on are preferably within the following ranges.

The minimum width of the flow channel of the molded product depends on the processing accuracy of the mask. In terms of industrial technology, the minimization would be possible with the use of a short wavelength laser such as a X-ray laser. However, since this invention aims at offering accurate and low-cost molded products widely for the medical, industrial, and biotechnological fields, the minimum width of the flow channel is preferably 5 µm to enable easy industrial reproduction.

Further, in application to unstandardized molded products of multi-kind small lot also, the width of the flow channel is preferably 5 µm or above to offer the product as an accurate and low-cost reservoir.

The maximum width of the flow channel is not limited; however, the width is preferably 300 µm or less to enable shorter diagnosis time and parallel processing, and provide portability to a system.

The minimum depth of the flow channel of the molded product is preferably 5 µm to function as a flow channel.

The maximum depth of the flow channel, on the other hand, is not limited. The flow channel depth, however, is preferably 300 µm or less to preserve the effects of reducing the flow channel width that enable diagnosis time reduction and parallel processing to provide portability to a system when used in chemical analysis, DNA diagnosis, and so on.

The minimum length of the flow channel is preferably 5 mm to allow sample injection and separation (analysis).

The maximum length of the flow channel, on the other hand, is not limited. The flow channel length, however, is preferably 300 µm or less to preserve the effects of reducing the flow channel length that enable diagnosis time reduction and parallel processing to provide portability to the system when used in chemical analysis, DNA diagnosis, and so on.

The minimum interval of the reservoirs of the molded product depends on the processing accuracy of the mask. In terms of industrial technology, the minimization would be possible with the use of a short wavelength laser such as a X-ray laser. However, since this invention aims at offering accurate and low-cost reservoirs widely for the medical, industrial, and biotechnological fields, the minimum interval of the reservoirs is preferably 5 µm to enable easy industrial reproduction.

In some cases, the minimum interval of the reservoirs is determined by the positioning accuracy of the blood test system, for example. It is thus preferred to select the minimum reservoir interval according to system specifications.

Further, in application to unstandardized molded products of multi-kind small lot also, the reservoir interval is preferably 5 µm or above to offer the product as an accurate and low-cost reservoir.

The maximum interval of the reservoirs is not limited; however, the reservoir interval is preferably 10,000 µm or less to allow parallel processing and provide portability to a system.

For the above reasons, the preferable range of the width (or diameter) of the reservoir of the molded product is also between 5 µm to 10,000 µm.

The minimum depth of the reservoir of the molded product is not limited, but it is preferably 10 µm to function as a reservoir.

As for the maximum depth of the reservoir, it would be possible to obtain a deeper pattern by means of performing a plurality of resist coating steps, using laser light such as X-ray beam as exposure light to ensure enough depth of focus, and so on. However, since this invention aims at offering accurate and low-cost reservoirs widely for the medical, industrial, and biotechnological fields, the reservoir maximum depth is preferably 1,000 µm to enable easy industrial reproduction.

The flatness of the molded product is preferably 1 µm or more to enable easy industrial reproduction.

The flatness of the molded product is preferably 200 µm or less in order not to cause a problem in the attachment of the molded product to another substrate.

The dimensional accuracy of the width and depth of the flow channel of the molded product is preferably within the range of ± 0.5 to 10% to enable easy industrial reproduction.

The dimensional accuracy of the interval, width (or diameter) and depth of the reservoir of the molded product is preferably within the range of ± 0.5 to 10% to enable easy industrial reproduction.

The dimensional accuracy of the thickness of the molded product is preferably within the range of ± 0.5 to 10% to enable easy industrial reproduction

The thickness of the molded product is not particularly specified, but it is preferably within the range of 0.2 to 10 mm to prevent breakage at removal in the injection molding, or breakage, deformation, or distortion during operation.

The size of the molded product is also not particularly specified, and it is preferably selected according to usage. For example, when forming the resist pattern by the lithography technique, if the resist layer is formed by spin coating, the molded product size is preferably within 400 mm in diameter.

The resin molded product produced by the process according to the present invention may be used for various applications, including chemical analysis, DNA diagnosis, medical applications such as a sample reservoir, an antibody reservoir, and a reagent reservoir, industrial applications such as microparticle arrangement, biotechnological applications such as cell processing, and automated chemical analysis such as a reaction reservoir.

In application to the medical field, particularly for use that requires biocompatibility such as antithrombogenicity (antiplatelet adhesion) and elimination of harmful effect in cytotoxicity tests, it is preferred to use a material having antithrombotic effects or conduct surface treatment.

An example of the technique to improve the biocompatibility by the surface treatment is to deposit a SiO2 layer by sputtering on the molded product produced by the injection molding, and then develop the SiO2 layer by thermal oxidation, thereby providing the biocompatibility to the product.

When the resin molded product is used in the medical field, particularly in the clinical laboratory field, for the biochemical analysis, the DNA diagnosis, and so on, it is sometimes necessary to perform processing such as warming, reaction, and signal detection on the resin molded product.

The warming or the reaction treatment may be performed on the resin molded product by forming an electrode pattern by sputtering to apply a voltage from the system, or by providing a heater. If the warming or the reaction treatment requires temperature control, a temperature sensor may be provided. The signal detection may be performed by providing photodiode.

When used in the medical field, particularly in the clinical laboratory field, for the biochemical analysis, the DNA diagnosis, and so on, a molded product preferably has a miniaturized flow channel to reduce diagnosis time. Such a molded product can be achieved by the resin molded product obtained by the present invention.

The resin molded product according to the present invention is accurate and low cost, thereby being effective for heavy-use applications such as biochemical analysis and DNA diagnosis, particularly at an operating room, bedside, home, local clinic, and so on.

In the industrial field, research and development for enhancing reflectivity of a retroreflective board used for a traffic sign and so on to improve visibility, and those for increasing luminance of a display of television, computer, and so on to achieve clear display have been conducted.

One approach to this requirement is to line up polymer particles with a given size selected from 10 to 100 µm on a display board or a display screen. If the polymer particles can be aligned in a line in contact with each other, it would allow the incident light in the normal or oblique direction, which is otherwise dispersed vertically, to be retroreflected in the normal direction due to the difference in refractive index of the polymer particle and the air at gaps, thereby increasing the luminance at the front to improve the visibility.

With conventional techniques, however, it has been unable to align the polymer particles with a given size in a line in contact with each other due to the limitation to the miniaturization of the reservoir or low productivity. By using the resin molded product according to this invention, it is possible to achieve the above approach.

For example, arrangement of the polymer particles with the diameter of 40 µm in a line in contact with each other is achieved by the resin molded product with the reservoir interval of 10 µm, reservoir diameter of 45 µm, depth of 25 µm, flatness of 10 µm or less, and dimensional accuracy of ± 5% or less.

After sorted to fall within the range of 40 µm ± 5% or less in diameter, the polymer particles are coated on the above reservoirs. The polymer particles are thereby uniformly dispersed over the entire molded product with one polymer particle in one reservoir.

If the above resin molded reservoir is attached to a substrate for the retroreflective board coated with adhesion, for example, the polymer particles becomes aligned in a layer in contact with each other. Though the particles are arranged with the reservoir interval of 10 µm immediately after the attachment of the resin molded product to the substrate for the retroreflective board and so on, they are gradually brought into contact with each other by surface tension of the adhesion before curing.

The resin molded product according to the present invention is accurate and low cost. Thus, when using the resin molded product for the polymer microparticle alignment to the retroreflective board and so on, it does not cost much to discard it and use a new one in the occurrence of defects such as contaminated surface and distortion, though a repeated use is also possible. The resin molded product is therefore particularly effective for heavy-use applications such as retroreflective boards for traffic signs and display screens for computers.

In the biotechnological field, since fusing of many cells is performed all at once, it has been difficult to fuse all the cells with different thickness of membrane, different degrees of activity, and so on, thus requiring extra work for sorting unfused cells from fused cells.

One solution to this problem is to arrange a pair (two) of cells for effective fusion of many cells. This can be achieved by using the resin molded product according to the present invention.

Firstly, if the cell size is 20 to 100 µm, a substrate with the reservoir interval of 800 µm, the reservoir width of 250 µm, depth of 250 µm, flatness of 50 µm or less, and the dimensional accuracy of ± 5% or less is produced by the above process. Then, to provide a separate electrode for each reservoir, after performing masking in accordance with an electrode pattern by sputtering, for example, an electrode material such as Pt + W/Cr is deposited, and an antioxidant layer such as SiO₂ is further deposited thereon. The resin molded product is thereby produced.

After that, a given cell is positioned in each of the above reservoirs in liquid. Electrical information is obtained by a voltage applied to a pair of electrodes formed in each reservoir. This enables the detection per reservoir.

The resin molded product according to the present invention is accurate and low cost. Thus, it does not cost much to discard it and use a new one in the occurrence of defects such as contaminated surface and distortion, though a repeated use is also possible. The resin molded product is therefore particularly effective for applications that requires high operating efficiency with reduced labor and time and so on.

Since the resin molded product according to the present invention is accurate and low cost, besides the medical, industrial, biotechnological fields, it is also widely applicable to the field of the automated chemical analysis such as combinatorial chemistry. Particularly, smaller sample requirements allow significant reduction of waste solution, thus being effective in terms of environmental preservation as well.

When producing the metal structure and the resin molded product by the process according to the present invention, a line mark parallel to the substrate may be created on a whole or part of a wall surface of the metal structure and the resin molded product as a trace of a border of a plurality of resist layers; however, it causes no practical problem.

### EXAMPLE

The process for producing the resin molded product according to the present invention will be explained hereinafter with reference to the drawings.

Referring first to Fig. 1(a), the first resist coating was performed on a substrate 1 with an organic material (AZP4400 manufactured by CLARIANT JAPAN K.K.) to form a resist layer 2. Then, the first exposure was performed on the resist layer 2, using a mask 3 patterned with a desired chamber, with UV light from an UV exposure system (UPE-500S with 365 nm wavelength and 20mV/cm2 illumination intensity, manufactured by USHIO U-TECH INC.).

Referring next to Fig. 1(b), the second resist coating was performed on the resist layer 2 with an organic material to form the resist layer 2. Then, mask positioning was performed to place the mask in the position corresponding to the mask pattern in the first exposure. The second exposure was then performed on the resist layer 2, using the mask 3, with UV light from the UV exposure system. The above steps were repeated a plurality of times as necessary to obtain a desired resist thickness.

Referring then to Fig. 1(c), development was performed on the substrate 1 having the resist layer 2 to create a resist pattern 4 on the substrate 1 (developer: AZ400K developer manufactured by CLARIANT JAPAN K.K.).

Referring now to Fig. 1(d), vapor deposition or sputtering was performed on the surface of substrate 1 with the resist pattern 4 to deposit a conductive layer formed of silver over the surface of the resist pattern. Platinum, gold, copper, or the like may be deposited instead of the silver in this step.

Referring then to Fig. 1(e), the substrate 1 having the resist pattern 4 was immersed in a plating solution for electroplating to deposit a Ni structure 6 in gaps between the resist pattern. Alternatively, copper, gold, or the like may be deposited in this step. After that, as shown in Fig. 1(f), the substrate 1 and the resist pattern 4 were removed, thereby producing the Ni structure 6.

Referring finally to Fig. 1(g), a plastic material is filled in the Ni structure 6, which serves as a mold. A plastic molded product 7 was thereby produced.

### EXAMPLE 1

### [Production of a molded product having a flow channel]

The resist layer formation step was repeated three times according to the molded product production process shown in Fig. 1. A molded product having a substrate with 60 mm in width, 50 mm in length, and 1.5 mm in thickness on which a flow channel with 100 µm in width and 100 µm in depth was created was thereby produced.

### EXAMPLE 2

### [Production of a molded product having a flow channel and a mixing part]

The resist layer formation step was repeated three times according to the molded product production process shown in Fig. 1. A molded product having a substrate with 50 mm in width, 70 mm in length, and 1.5 mm in thickness on which a flow channel with 100 µm in width and 100 µm in depth and a mixing part were created was thereby produced.

### EXAMPLE 3

### [Production of a molded product having a reservoir]

The resist layer formation step was repeated seven times according to the molded product production process shown in Fig. 1. A molded product having a substrate with 60 mm in width, 40 mm in length, and 1.5 mm in thickness on which a reservoir with 200 µm in width and 250 µm in depth was created was thereby produced.

The molded product produced by the process according to the present invention has higher dimensional accuracy and so on than conventional molded products. In addition to being accurate, this molded product is low in production cost. The molded product is thus particularly effective for heavy-use applications to take maximum advantage of the minimum production costs.

### Industrial Applicability

As explained in the foregoing, the process according to the present invention is particularly effective in producing resin molded products used for diagnosis, reaction, separation, and measurement in the medical, industrial, and biotechnological fields, for example. The molded product according to this invention, and particularly those used in the medical field, has a microstructure and thus allows shortening of measuring time, reduction of a sample amount, and parallel processing. Thus, the product is especially effective in use for diagnosis at a medical center clinical laboratory, bedside, operating room, local clinic, home, and so on.

## Claims

1. A process for producing a resin molded product, comprising:
a resist pattern formation step comprising forming a resist layer on a substrate and performing exposure using a mask and development;
a metal structure formation step for depositing by plating a metal structure in accordance with the resist pattern formed on the substrate; and
a molded product formation step for forming a resin molded product by using the metal structure as a mold;
wherein the resist pattern formation step includes:
a step for forming a first resist layer on the substrate and performing exposure on the first resist layer; and
a step for forming a second resist layer on the first resist layer and performing exposure, or exposure and development on the second resist layer
and wherein the depth of a concave part of the resin molded product formed by the molded product formation step is 20 to 500 µm.

2. A process for producing a resin molded product according to claim 1, wherein the resist pattern formation step is repeated a plurality of times until a desired thickness of the resist layer is reached.

3. A process for producing a resin molded product according to claim 1 or 2, wherein the mask position is adjusted for the exposure of the second resist layer to be in the same position as for the exposure of the first resist layer.

4. A process for producing a resin molded product according to any of claims 1 to 3, wherein a light source used for the exposure in the resist pattern formation step is an ultraviolet lamp or a laser.

5. A process for producing a resin molded product according to claim 1, wherein the depth of a concave part of the resin molded product formed by the molded product formation step is 50 to 300 µm.

6. A process for producing a metal mold, comprising:
a resist pattern formation step comprising forming a resist layer on a substrate and performing exposure using a mask and development; and
a metal structure formation step for depositing by plating a metal structure in accordance with the resist pattern formed on the substrate to form a metal mold,
wherein the resist pattern formation step includes:
a step for forming a first resist layer on the substrate and performing exposure on the first resist layer; and
a step for forming a second resist layer on the first resist layer and performing exposure, or exposure and development on the second resist layer,
wherein the metal mold is such that the depth of a concave part of a resin molded product formed by using the metal mold is 20 to 500 µm.

7. A process for producing a metal mold according to claim 6, wherein the resist pattern formation step is repeated a plurality of times until a desired thickness of the resist layer is reached.

8. A process for producing a metal mold according to claim 6 or 7, wherein the mask position is adjusted for the exposure of the second resist layer to be in the same position as for the exposure of the first resist layer.

## Patentansprüche

1. Ein Verfahren zur Herstellung eines geformten Harzproduktes, umfassend:
einen Schritt des Bildens eines Resistmusters, umfassend das Bilden einer Resistschicht auf einem Substrat und Durchführen von Belichtung unter Verwendung einer Maske und Entwicklung;
einen Schritt des Bildens einer Metallstruktur zum Abscheiden durch Aufbringen einer Metallstruktur entsprechend dem Resistmuster, das auf dem Substrat gebildet ist; und
einen Schritt des Bildens eines geformten Produkts zum Bilden eines geformten Harzproduktes durch Verwendung der Metallstruktur als eine Form;
wobei der Schritt des Bildens des Resistmusters einschließt:
einen Schritt des Bildens einer ersten Resistschicht auf dem Substrat und Durchführen von Belichtung auf der ersten Resistschicht; und
einen Schritt des Bildens einer zweiten Resistschicht auf der ersten Resistschicht und Durchführen von Belichtung, oder Belichtung und Entwicklung auf der zweiten Resistschicht,
und wobei die Tiefe eines konkaven Teils des geformten Harzproduktes, welches durch den Schritt des Bildens eines geformten Produkts gebildet wurde, 20 bis 500 µm beträgt.

2. Ein Verfahren zur Herstellung eines geformten Harzprodukts gemäß Anspruch 1, wobei der Schritt des Bildens des Resistmusters mehrere Male wiederholt wird, bis eine gewünschte Dicke der Resistschicht erreicht wird.

3. Ein Verfahren zur Herstellung eines geformten Harzprodukts gemäß Anspruch 1 oder 2, wobei die Position der Maske für die Belichtung der zweiten Resistschicht so eingestellt wird, dass sie sich in der gleichen Position befindet, wie bei der Belichtung der ersten Resistschicht.

4. Ein Verfahren zur Herstellung eines geformten Harzprodukts gemäß einem der Ansprüche 1 bis 3, wobei eine Lichtquelle, welche zur Belichtung beim Schritt des Bildens des Resistmusters verwendet wird, eine UV-Lampe oder ein Laser ist.

5. Ein Verfahren zur Herstellung eines geformten Harzprodukts gemäß Anspruch 1, wobei die Tiefe eines konkaven Teils des geformten Harzproduktes, welches durch den Schritt des Bildens eines geformten Produkts gebildet wurde, 50 bis 300 µm beträgt.

6. Ein Verfahren zur Herstellung einer Metallform, umfassend:
einen Schritt des Bildens eines Resistmusters, umfassend das Bilden einer Resistschicht auf einem Substrat und Durchführen von Belichtung unter Verwendung einer Maske und Entwicklung;
einen Schritt des Bildens einer Metallstruktur zum Abscheiden durch Aufbringen einer Metallstruktur entsprechend dem Resistmuster, das auf dem Substrat gebildet ist, um eine Metallform zu bilden,
wobei der Schritt des Bildens eines Resistmusters einschließt:
einen Schritt des Bildens einer ersten Resistschicht auf dem Substrat und Durchführen von Belichtung auf der ersten Resistschicht; und
einen Schritt des Bildens einer zweiten Resistschicht auf der ersten Resistschicht und Durchführen von Belichtung, oder Belichtung und Entwicklung auf der zweiten Resistschicht,
wobei die Metallform derart ist, dass die Tiefe eines konkaven Teils eines geformten Harzprodukts, welches durch die Verwendung der Metallform gebildet wurde, 20 bis 500 µm beträgt.

7. Ein Verfahren zur Herstellung einer Metallform gemäß Anspruch 6, wobei der Schritt zum Bilden des Resistmusters mehrere Male wiederholt wird, bis eine gewünschte Dicke der Resistschicht erreicht ist.

8. Ein Verfahren zur Herstellung einer Metallform gemäß Anspruch 6 oder 7, wobei die Position der Maske für die Belichtung der zweiten Resistschicht so eingestellt wird, dass sie sich in der gleichen Position befindet, wie bei der Belichtung der ersten Resistschicht.

## Revendications

1. Procédé pour produire un produit moulé en résine, comprenant :
une étape de formation de motif de réserve incluant de former une couche de réserve sur un substrat et de réaliser une exposition en utilisant un masque et un développement ;
une étape de formation de structure métallique pour déposer par placage une structure métallique selon le motif de réserve formé sur le substrat ; et
une étape de formation de produit moulé pour former un produit moulé en résine en utilisant la structure métallique comme moule ;
dans lequel l'étape de formation de motif de réserve inclut :
une étape pour former une première couche de réserve sur le substrat et réaliser une exposition sur la première couche de réserve ; et
une étape pour former une seconde couche de réserve sur la première couche de réserve et réaliser une exposition, ou une exposition et un développement sur la seconde couche de réserve,
et dans lequel la profondeur d'une partie concave du produit moulé en résine formé par l'étape de formation de produit moulé est de 20 à 500 µm.

2. Procédé pour produire un produit moulé en résine selon la revendication 1, dans lequel l'étape de formation de motif de réserve est répétée plusieurs fois jusqu'à ce qu'une épaisseur souhaitée de la couche de réserve soit atteinte.

3. Procédé pour produire un produit moulé en résine selon la revendication 1 ou 2, dans lequel la position du masque est ajustée pour que l'exposition de la seconde couche de réserve soit dans la même position que pour l'exposition de la première couche de réserve.

4. Procédé pour produire un produit moulé en résine selon l'une quelconque des revendications 1 à 3, dans lequel une source de lumière utilisée pour l'exposition dans l'étape de formation de motif de réserve est une lampe à ultraviolet ou un laser.

5. Procédé pour produire un produit moulé en résine selon la revendication 1, dans lequel la profondeur d'une partie concave du produit moulé en résine formé par l'étape de formation de produit moulé est de 50 à 300 µm.

6. Procédé pour produire un moule métallique comprenant :
une étape de formation de motif de réserve incluant de former une couche de réserve sur un substrat et de réaliser une exposition utilisant un masque et un développement ;
une étape de formation de structure métallique pour déposer par placage une structure métallique selon le motif de réserve formé sur le substrat pour former un moule métallique ;
dans lequel l'étape de formation de motif de réserve inclut :
une étape pour former une première couche de réserve sur le substrat et réaliser une exposition sur la première couche de réserve ; et
une étape pour former une seconde couche de réserve sur la première couche de réserve et réaliser une exposition, ou une exposition et un développement sur la seconde couche de réserve,
dans lequel le moule métallique est tel que la profondeur d'une partie concave d'un produit moulé en résine formé par l'utilisation du moule métallique est de 20 à 500 µm.

7. Procédé pour produire un moule métallique selon la revendication 6, dans lequel l'étape de formation de motif de réserve est répétée plusieurs fois jusqu'à ce qu'une épaisseur souhaitée de la couche de réserve soit atteinte.

8. Procédé pour produire un moule métallique selon la revendication 6 ou 7, dans lequel la position du masque est ajustée pour que l'exposition de la seconde couche de réserve soit dans la même position que pour l'exposition de la première couche de réserve.
